# FASCICULE DE BREVET EUROPEEN

(11) **EP 3 423 614 B1**
(45) Date de publication et mention de la délivrance du brevet: **09.12.2020**
(21) Numéro de dépôt: 17707352.5
(22) Date de dépôt: 02.03.2017
(51) Int. Cl.: C30B 29/40, H01L 21/20

(54) **PROCEDE DE FABRICATION D'UN SUBSTRAT SEMI-CONDUCTEUR DE NITRURE D'ÉLÉMENT DE GROUPE 13 ET SUBSTRAT SEMI-CONDUCTEUR DE NITRURE D'ÉLÉMENT DE GROUPE 13**
VERFAHREN ZUR HERSTELLUNG EINES III-NITRID HALBLEITERSUBSTRATS UND III-NITRID HALBLEITERSUBSTRAT
METHOD FOR FABRICATING A GROUP 13 NITRIDE SEMICONDUCTOR SUBSTRATE AND GROUP 13 NITRIDE SEMICONDUCTOR SUBSTRATE

(30) Priorité: 04.03.2016 FR 1651853
(43) Date de publication de la demande: 09.01.2019
(73) Titulaire: Saint-Gobain Lumilog, 92400 Courbevoie (FR)
(72) Inventeur: BEAUMONT, Bernard, 06530 Le Tignet (FR); FAURIE, Jean-Pierre, 06560 Valbonne (FR)
(74) Mandataire: Regimbeau
(86) Numéro de dépôt international: PCT/EP2017/054918
(87) Numéro de publication internationale: WO 2017/149079

(56) Documents cités:
- WO-A1-2010/112540
- WO-A1-2012/052513
- FR-A1- 2 944 137
- JP-A- 2011 213 512
- US-A1- 2007 259 504
- US-A1- 2014 054 595

## Description

### DOMAINE DE L'INVENTION

L'invention concerne le domaine technique général de la fabrication de substrats et de plaquettes - ou « wafer » selon la terminologie anglo-saxonne - en un matériau semi-conducteur à base d'éléments des colonnes 13 et 15 du tableau périodique - tel que le nitrure de gallium GaN.

Ces plaquettes peuvent être destinées à la réalisation de structures semi-conductrices, telles que des diodes électroluminescentes (DEL), ou des diodes laser (DL).

### ETAT DE LA TECHNIQUE

Les procédés actuels de fabrication de substrat de matériau semi-conducteur à base de nitrure d'élément de la colonne 13 reposent sur les techniques de dépôt en phase vapeur, en particulier l'hétéro-épitaxie qui consiste à faire croître un cristal - tel qu'un cristal de nitrure de gallium GaN-sur un substrat de départ de nature différente - tel qu'un substrat de saphir.

Ces méthodes font intervenir un système d'injection à partir d'au moins deux composants gazeux différents, susceptibles d'interagir avant dépôt.

On peut citer les méthodes bien connues comme :
- l'Epitaxie en Phase Vapeur aux OrganoMétalliques (« MOVPE », sigle de l'expression anglo-saxonne «MetalOrganic Vapour Phase Epitaxy »),
- l'Epitaxie en Phase Vapeur aux Halogénures (ou « HVPE », sigle de l'expression anglo-saxonne « *Hydride Vapor Phase Epitaxy* »),
- l'Epitaxie par Transport de Vapeur en Espace Clos (ou « *CSVT* » sigle de l'expression anglo-saxonne « *Close-Spaced Vapor Transport* »),
- le dépôt céramique en phase vapeur, etc.

Le procédé d'hétéro-épitaxie conduit à des macro-défauts appelés « pits » en anglais. Ce type de défaut correspond à un creux ou un puits permanent, voire un trou traversant l'épaisseur du dépôt, de section décroissante dans le sens opposé à la direction de croissance et dont la largeur et la profondeur augmentent lorsque l'épaisseur du dépôt s'accroît.

Typiquement un tel trou peut mesurer jusqu'à 1mm de diamètre et 1.5mm de profondeur, contrairement aux défauts de type dislocations qui sont quant à eux de dimensions de l'ordre du micromètre.

Un tel creux (puits permanent) ne peut pas être enlevé par les méthodes de croissances usuelles, incluant par exemple, une alternance entre des modes de croissance 3D/2D.

Ces creux ne sont pas souhaitables, car ils n'ont pas de fonction radiative et pénalisent fortement la performance de la diode.

Ils sont d'autant plus dommageables que l'on souhaite généralement réaliser des dépôts de forte épaisseur, lesquels présentent une plus grande qualité cristalline. En effet, la densité de défauts cristallins, tels que les dislocations, diminue lorsque l'épaisseur du dépôt augmente.

De tels trous structuraux non traversants ou permanents sont par exemple décrits dans le document WO2013/144709A2. Pour supprimer ces trous non traversants, la publication WO2013/144709A2 propose dans un premier temps d'usiner la face opposée à la face de croissance. Dans un deuxième temps, les trous débouchants ainsi créés sont comblés par croissance épitaxiale.

Une telle méthode suppose cependant une étape d'usinage séparée du procédé de dépôt proprement dit. Ce procédé impose donc une étape additionnelle représentant un ajout de complexité, ainsi qu'un coût supplémentaire conséquent, notamment en termes de perte de matière.

Les publications US2010/0124814, WO2010/112540-A1, US2007/259504-A1, US2014/054595, FR2944137-A, WO2012/052513-A1 divulguent un substrat comportant une couche monocristalline de nitrure d'élément III présentant des puits de croissance, ayant pour origine des dislocations de croissance.

La solution proposée par US2010/0124814 est de refermer ces puits lors de la croissance épitaxiale de la couche supérieure. Une couche intermédiaire de nitrure ou d'oxyde de Silicium est déposée de façon discontinue sur uniquement certaines parties des puits et du reste de la couche monocristalline. Cette couche intermédiaire constitue une couche de masquage discontinue qui permet de réduire la nucléation et permet la fermeture des puits par croissance latérale de la couche supérieure au-dessus des creux.

Le document WO2010/112540-A1, qui est considéré comme l'état de l'art le proche à l'invention, divulgue toutes les caractéristiques de l'invention sauf l'élimination du substrat, sa rectification, et le bouchage des défauts structuraux nontraversants avec du matériau polycristallin.

Un tel processus réduit fortement les dislocations de la structure réalisée, grâce à l'obturation des puits. Il crée toutefois à l'intérieur de la structure de nombreuses cavités et donc une densité de défauts structuraux non traversants creux importante (très supérieure à 5%).

Il existe donc un besoin pour un procédé, moins complexe et plus économique, permettant la fabrication des tranches de matériau semi-conducteur très homogènes, présentant une densité de défauts macrostructuraux non traversants très faibles, notamment des tranches de matériau de nitrure d'élément 13 du tableau périodique, plus particulièrement des tranches composées de GaN.

### PRESENTATION DE L'INVENTION

On entend, dans le cadre de la présente invention, par dépôt polycristallin, un dépôt comprenant des grains cristallisés de petite taille ou une structure ordonnée d'orientation aléatoire, d'orientation non imposée par le support et désorientés entre eux formant ainsi une mosaïque.

On entend par couche « microcristalline » une couche formée de microcristaux ou microcristallites typiquement de l'ordre de 0.01 à 10 micromètres de diamètre équivalent.

Par couche amorphe, on entend une couche comportant au moins 50% en masse d'une phase d'orientation désordonnée ou vitreuse, c'est-à-dire non cristallisée ou microcristalline.

Compte-tenu des problématiques évoquées ci-avant, un but de la présente invention est donc de réduire, voire d'éliminer l'impact des défauts macrostructuraux des couches épitaxiales de forte épaisseur, typiquement plus de 200 micromètres voire plus 300, voire même 500 micromètres ou plus, lors du processus d'épitaxie, c'est-à-dire sans étape séparée du processus de croissance.

Un autre objectif de l'invention est d'obtenir des tranches de matériau semi-conducteur de forte épaisseur (typiquement plus de 200 micromètres voire plus 300, voire même 500 micromètres ou plus), offrant les meilleures qualités cristallines (largeur de raie de double diffraction aux rayons X (DDX) de l'ordre de 100 arcsec ou moins) et présentant une densité surfacique de défauts macrostructuraux non traversants inférieure à 5%, de préférence inférieure à 2%, voire même inférieure à 1,5%.

À cet égard, l'invention a pour objet un procédé de fabrication d'un substrat de semi-conducteur de nitrure d'élément de groupe selon la revendication 1.

Avantageusement, mais facultativement, le procédé selon l'invention peut, en outre, comprendre au moins une des caractéristiques suivantes :
- lors de l'étape de dépôt par croissance épitaxiale d'au moins une couche polycristalline continue, on met en œuvre une croissance épitaxiale à une température inférieure de plus de 100°C (préférentiellement de plus de 200°C et encore plus préférentiellement de plus de 300°C) à la température de croissance lors du dépôt de la couche monocristalline.
- lors de l'étape de dépôt par croissance épitaxiale d'au moins une couche polycristalline continue, on met en œuvre une croissance épitaxiale à une température de croissance de 700°C ou moins, voire 600°C ou moins.
- lors de l'étape de dépôt par croissance épitaxiale d'au moins une couche polycristalline continue, on met en œuvre une croissance épitaxiale à une vitesse de croissance supérieure à 1000 micromètres/h et/ou d'au moins 10 fois la vitesse de croissance de la couche monocristalline
- lors de l'étape de dépôt par croissance épitaxiale d'au moins une couche polycristalline continue, on met en œuvre une étape préalable de détermination des défauts structuraux non traversants de diamètre équivalent et/ou de profondeur de 20 à 1000 micromètres.
   ∘
   ∘ la couche amorphe et/ou microcristalline comporte une épaisseur de 0.1 à 0.5 micromètre, de préférence inférieure à 0.2 micromètre.
   ∘ le dépôt de la couche amorphe et/ou microcristalline comprend une température de croissance comprise entre 900 et 1150°C.
- la couche monocristalline de nitrure d'élément 13 est une couche de nitrure de gallium.
- la couche polycristalline de nitrure d'élément 13 est une couche de nitrure de gallium.
- La couche monocristalline comporte une épaisseur supérieure à 300 micromètres, ou supérieure à 500 micromètres.
- la couche polycristalline comporte une épaisseur comprise entre 0.1 à 1 mm, ou comprise entre 0.1 à 0.5 mm.

L'invention a également pour objet un substrat de matériau semi-conducteur de nitrure d'élément 13 selon la revendication 11.

### DESCRIPTION DES FIGURES

D'autres caractéristiques, buts et avantages de la présente invention apparaîtront à la lecture de la description détaillée qui va suivre, au regard des figures annexées, données à titre d'exemples non limitatifs et sur lesquelles :
- La figure 1 résume les principales étapes du procédé de fabrication de substrat selon un mode de mise en œuvre de l'invention.
- La figure 2 représente schématiquement un matériau semi-conducteur composé d'un empilement de couches selon l'invention.
- La figure 3A illustre les étapes de dépôt (bouchage) par une couche polycristalline, puis de rectification selon un premier mode de mise en œuvre ne faisant pas partie de l'invention,
- La figure 3B illustre les étapes de dépôt (bouchage) par une couche polycristalline, puis de rectification selon un second mode de mise en œuvre possible de l'invention,
- La figure 4 illustre comparativement la mise en œuvre des mêmes étapes avec une étape de dépôt (bouchage) par une couche d'une couche monocristalline,
- La figure 5A illustre un cristal de nitrure d'élément 13 autosupporté obtenu selon un mode de mise en œuvre possible de l'invention.
- La figure 5B illustre un cristal de nitrure d'élément 13 autosupporté obtenu, après rectification selon un mode de mise en œuvre possible de l'invention.

### DESCRIPTION DETAILLEE D'AU MOINS UN MODE DE REALISATION

### DE L'INVENTION

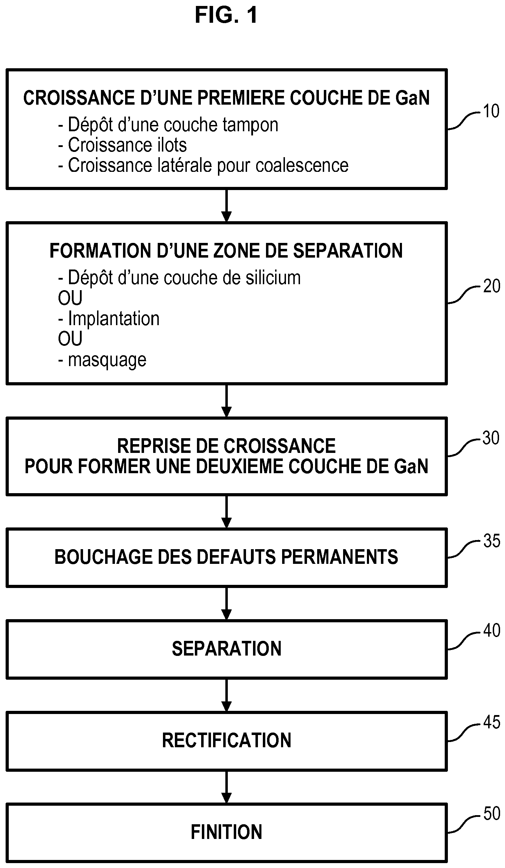

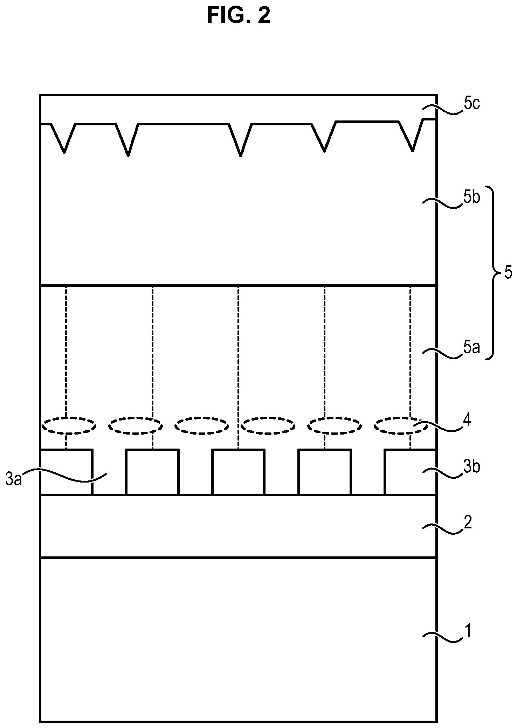

En référence aux figures 1 et 2, on a illustré les grandes phases du procédé de fabrication de plaquettes de GaN.

Dans la suite, on décrira le procédé selon l'invention en référence à la fabrication de plaquettes de nitrure de gallium GaN.

Toutefois, il est bien évident pour l'homme du métier que le procédé décrit ci-dessous peut être utilisé pour faire croître un matériau incluant une couche de nitrure d'élément 13 autre que du nitrure de gallium GaN.

### 1. Procédé de fabrication

Le procédé comprend :
- une phase 10 de croissance d'une première couche de nitrure d'élément 13 préférentiellement de GaN 5a ;
- une phase 20 de formation d'une zone de séparation 4 ;
- une phase 30 de reprise d'épitaxie pour former une deuxième couche épaisse de GaN 5b ;
- une phase 35 de bouchage des défauts structuraux non traversants de type creux ou puits ;
- une phase 40 de séparation pour obtenir un cristal de GaN 5 ;
- une phase 45 de rectification pour enlever une épaisseur de la deuxième couche épaisse de GaN 5b;
- une phase 50 de finition pour former des plaquettes de GaN à partir du cristal de GaN 5.

### 1.1. Phase 10 de croissance

La phase de croissance 10 consiste à former une première couche de GaN 5a par surcroissance latérale.

La surcroissance latérale permet de minimiser la densité de défauts contenus dans la première couche de GaN 5a.

L'approche utilisée pour réduire la densité de dislocations dans la première couche de GaN 5a consiste à :
- initier un mode de croissance du GaN par îlots, puis à
- favoriser la coalescence des îlots pour obtenir la première couche de GaN 5a.

Avantageusement, la surcroissance latérale est mise en œuvre sur un substrat de départ 1 présentant un angle de troncature non nul.

Le fait d'utiliser un substrat de départ 1 présentant un angle de troncature non nul permet de faire croître une première couche de GaN 5a ayant un angle de troncature non nul. L'angle de troncature peut être compris entre 0.1 et 5 degrés, préférentiellement entre 0.2 et 0.8 degré, et encore plus préférentiellement entre 0.3 et 0.6 degré (notamment pour limiter les fautes d'empilement).

Le substrat de départ 1 peut être choisi parmi Si, AlN, GaN, GaAs, Al2O3 (saphir), ZnO, SiC, LiAlO2, LiGaO2, MgAl2O4, 4H-SiC, ou tout autre type de substrat de départ connu par l'homme du métier pour mettre en œuvre une croissance de nitrure de gallium. Il peut présenter une épaisseur de quelques centaines de micromètres, généralement 350 micromètres.

Avantageusement, le substrat de départ 1 peut être traité par nitruration préalablement à toute étape de dépôt. Cela permet d'améliorer la qualité du cristal de GaN obtenu.

La croissance de la première couche de GaN 5a peut être mise en œuvre selon différentes variantes. Notamment, la surcroissance latérale peut être basée :
- sur l'utilisation d'un masque diélectrique 3a, 3b incluant des ouvertures 3a dans lesquelles se forment les îlots, tel que décrit dans le document WO99/20816 ;
- sur l'utilisation d'une couche de diélectrique dépourvue d'ouverture sur laquelle se forment spontanément des îlots, telle que décrite dans le document EP 1 338 683.

### 1.1.1. Première variante de surcroissance latérale

Dans une première variante, la phase 10 de croissance consiste en une surcroissance latérale épitaxiale (ci-après dénommée « ELO » selon l'acronyme de l'expression anglo-saxonne « Epitaxial Lateral Overgrowth »). L'ELO comprend une étape de dépôt d'une couche tampon 2 sur le substrat de départ 1.

Ce dépôt est de préférence réalisé par épitaxie phase vapeur aux organométalliques (ou « MOVPE », sigle de l'expression anglo-saxonne « MetalOrganic Vapour Phase Epitaxy »), par exemple à une température comprise entre 500°C et 700°C, notamment de 600°C.

Le dépôt d'une couche tampon 2 permet de réduire les contraintes entre le substrat de départ 1 et la première couche de GaN 5a épitaxiée par la suite sur celui-ci. En effet, le dépôt de la couche tampon 2 sur le substrat 1 permet d'assurer une transition « douce » entre le substrat 1 et la première couche de GaN 5a dont les structures cristallines sont différentes.

Le dépôt de la couche tampon 2 permet en outre de faciliter la séparation ultérieure du cristal de GaN 5, comme il ressortira de la description qui va suivre. La couche tampon 2 est par exemple une couche de GaN, une couche d'AlN, ou une couche d'AlGaN.

Dans une autre étape, un masque 3a, 3b incluant des ouvertures 3a est formé. Les ouvertures 3a peuvent être ponctuelles ou sous forme de bandes, et permettent de définir des positions pour la croissance sélective ultérieure d'ilots de GaN.

Le masque 3a, 3b peut être un masque en matériau diélectrique, par exemple du SiNx (SiN, Si3N4, etc.) ou du SiO2 ou du TiN. Ceci permet de minimiser les défauts créés en bord de masque et améliore ainsi la qualité de la couche de GaN épitaxiée ultérieurement sur celui-ci.

La formation du masque 3a, 3b peut être réalisée par toute technique connue de l'homme du métier. Par exemple, la formation du masque peut consister en :
- le dépôt d'une couche de diélectrique 3a à partir de précurseurs gazeux de silane et d'ammoniac directement sur la couche tampon 2, et
- la gravure par photolithographie de la couche de diélectrique 3a pour former des ouvertures 3a.

On obtient ainsi un substrat de départ 1 recouvert d'une couche tampon 2 et d'un masque 3a, 3b. Outre sa fonction d'amélioration de la qualité de la première couche de GaN 5a (par filtration des défauts traversants), le masque 3a, 3b permet de fragiliser l'interface entre le substrat de départ 1 et la première couche de GaN 5a.

Une autre étape consiste à former des îlots de GaN à travers les ouvertures 3a du masque. La vitesse de croissance selon un axe orthogonal au plan principal du substrat de départ 1 est maintenue supérieure à la vitesse de croissance latérale. On obtient ainsi des îlots ou des bandes à sections triangulaires (en fonction de la forme des ouvertures 3a). A l'intérieur de ces bandes à section triangulaire, les dislocations traversantes sont courbées à 90°.

On procède ensuite à une surcroissance latérale pour aboutir au final à une couche plane ELO. On obtient à la fin de cette étape du procédé une première couche de GaN 5a présentant une densité de dislocations inférieure à 10⁷cm⁻².

### 1.1.2. Deuxième variante de surcroissance latérale

Dans une deuxième variante, la phase 10 de croissance consiste en une surcroissance latérale universelle (ci-après dénommée « ULO » selon l'acronyme de l'expression anglo-saxonne « Universal Lateral Overgrowth ») telle que décrite dans le document EP 1 977 028.

L'ULO comprend une étape de dépôt d'une couche de nucléation sur le substrat de départ 1. La couche de nucléation est par exemple un film très mince de nitrure de silicium SiN, de l'ordre de quelques plans atomiques, autrement dit de l'ordre de 10 nm à 20 nm d'épaisseur. Le dépôt de SiN à base de silane et d'ammoniac peut durer 360 secondes.

Une couche tampon 2 continue - par exemple de GaN - est ensuite déposée sur la couche de nucléation. Le dépôt de la couche tampon 2 de GaN permet de filtrer les défauts cristallins et ainsi de minimiser dès le début du procédé la densité de défauts qui seront présents dans la première couche de GaN 5a épitaxiée par la suite.

L'épaisseur de cette couche tampon 2 de GaN peut être comprise entre 10 et 100 nm. La température lors de cette opération peut être comprise entre 500 et 700°C.

On procède ensuite à un recuit à haute température comprise entre 900 et 1150°C. Sous l'effet conjoint de l'élévation de la température, de la présence dans le véhicule gazeux d'une quantité d'hydrogène suffisante et de la présence du film très mince de SiN, la morphologie de la couche tampon 2 de GaN subit une profonde modification résultant d'une recristallisation en phase solide par transport de masse. La couche tampon 2 de GaN initialement continue est alors convertie en une couche discontinue de motifs de GaN. On obtient ainsi des motifs ou îlots de GaN de très bonne qualité cristalline et conservant une relation d'épitaxie avec le substrat de départ grâce à la très faible épaisseur de la couche de nucléation.

Les zones où le nitrure de silicium SiN est mis à nu fonctionnent alors comme un masque et les motifs de GaN fonctionnent comme les zones de GaN localisées dans les ouvertures réalisées ex-situ dans le masque. On procède ensuite à une surcroissance latérale pour aboutir au final à une couche plane ULO.

Cette méthode, où le masque de nitrure de silicium se forme spontanément, et qui fait intervenir les mêmes mécanismes de courbure des dislocations que dans l'ELO est identifiée comme « ULO » (ou « ELO spontané »).

### 1.2. Phase 20 de formation d'une zone de séparation 4

Le procédé comprend de plus une phase 20 de formation d'une zone de séparation 4.

Cette phase 20 de formation d'une zone de séparation peut être mise en œuvre selon différentes variantes. En particulier, la phase 20 de formation de la zone de séparation peut être mise en œuvre :
- préalablement à la phase 10 de croissance de la première couche de GaN (première variante), ou
- postérieurement à la phase 10 de croissance de la première couche de GaN (deuxième variante), ou
- pendant la phase 10 de croissance de la première couche de GaN (troisième variante).

### 1.2.1. Première variante de formation de la zone de séparation 4

Dans une première variante, la phase 20 de formation d'une zone de séparation 4 peut consister à déposer une couche intermédiaire de silicium Si, préalablement à la phase 10 de croissance de la première couche de GaN 5a, tel que décrit dans le document EP 1 699 951.

La couche intermédiaire de silicium Si sert de couche sacrificielle destinée à être vaporisée spontanément lors de la phase ultérieure de croissance par épitaxie de la première couche de GaN 5a.

La vaporisation spontanée de la couche intermédiaire de silicium Si lors de la phase de croissance de la première couche de GaN 5a permet de réduire la densité de défauts cristallins (en particulier de dislocations) à l'intérieur de la première couche de GaN 5a.

### 1.2.2. Deuxième variante de formation de la zone de séparation

Dans une deuxième variante, la phase 20 de formation d'une zone de séparation 4 comprend une étape d'implantation réalisée après la phase 10 de croissance de la première couche de GaN 5a. Cette implantation permet la création d'une zone fragilisée dans la première couche de GaN 5a.

L'implantation consiste à bombarder d'ions la première couche de GaN 5a de sorte à créer dans le semi-conducteur, à une profondeur voisine de la profondeur moyenne de pénétration de ces ions, une couche de microcavités (ou bulles).

Les ions implantés peuvent être choisis parmi le Tungstène, l'Hélium, le Néon, le Krypton, le Chrome, le Molybdène, le Fer, l'Hydrogène, ou le Bore. De préférence, les ions implantés sont des ions de tungstène. Ceux-ci présentent la particularité de décomposer le GaN.

En termes de dose, lorsque les ions implantés sont des ions H+, la dose d'ions implantés peut être comprise entre 10¹⁶ et 10¹⁷ cm⁻², et la profondeur d'implantation peut varier entre 0 nm et 50 nm en partant de la surface libre - appelée face de croissance - de la première couche de GaN 5a.

L'implantation d'ions de fragilisation peut être mise en œuvre lors d'une étape unique ou lors d'étapes successives. La température peut être comprise entre 4K et 1000K lors de l'étape d'implantation.

### 1.2.3. Troisième variante de formation de la zone de séparation

Dans une troisième variante, la zone de séparation 4 peut être formée pendant la phase 10 de croissance de la première couche de GaN 5a.

Notamment lorsque la phase de croissance est réalisée selon la première variante de réalisation dite ELO (i.e. dépôt d'un masque de diélectrique 3a, 3b), la phase 20 de formation de la zone de séparation 4 peut comprendre l'implantation de la couche tampon 2 préalablement au dépôt du masque 3a, 3b.

Cela permet de placer la zone de séparation 4 à une profondeur précisément souhaitée du fait que la première couche de GaN 5a déposée lors de l'étape de surcroissance ELO ne « gêne » pas l'implantation d'ions.

Bien entendu, l'implantation peut être effectuée à différents stades de la phase de surcroissance latérale ELO (ou ULO), soit dans les îlots, soit à un stade intermédiaire où les îlots ne sont pas entièrement coalescés, soit après coalescence totale des îlots.

### 1.3. Phase de reprise d'épitaxie 30

A l'issue des phases 20 de formation d'une zone de séparation 4 et de croissance 10 de la première couche de GaN 5a, le procédé comprend une phase de reprise d'épitaxie 30 pour former une deuxième couche épaisse de GaN 5b.

Cette reprise par épitaxie peut être mise en œuvre par :
- Epitaxie en Phase Vapeur aux OrganoMétalliques (« MOVPE »),
- Epitaxie en Phase Vapeur aux Halogénures (ou « HVPE », sigle de l'expression anglo-saxonne « Hydride Vapor Phase Epitaxy »),
- Transport de Vapeur en Espace Clos (ou « CSVT » sigle de l'expression anglo-saxonne « Close-Spaced Vapor Transport »), ou encore par
- Epitaxie en Phase Liquide (ou « LPE » sigle de l'expression anglo-saxonne « Liquide Phase Epitaxy »).

On préfère lors de cette étape mettre en œuvre la technologie « HVPE » qui permet l'obtention de trois principaux effets intéressants :
- un premier effet est que la première couche de GaN 5a est épaissie sans perdre ses qualités cristallines (on ne génère ni nouvelle dislocation, ni fissure),
- un deuxième effet est que l'on réduit encore la densité de dislocation lors de reprise d'épitaxie en HVPE, d'un facteur au moins égal à 2,
- un troisième effet est que la couche épaisse de GaN 5 ainsi obtenue se sépare spontanément de son substrat de départ 1 au niveau de la zone de séparation 4.

On obtient ainsi une deuxième couche de GaN monocristalline 5b s'étendant sur la première couche de GaN 5a. La deuxième couche de GaN monocristalline 5b présente un angle de troncature non nul de valeur constante sur sa face avant.

Les conditions de croissance de cette deuxième couche monocristalline 5b sont typiquement une température de croissance comprise entre 900 à 1150°C, avec une vitesse de croissance pouvant être comprise entre 50 et 500 micromètres /h, de préférence entre 100 et 150 micromètres /h.

La couche monocristalline comporte une épaisseur supérieure à 300 micromètres, ou de préférence supérieure à 500 micromètres et présente des macrodéfauts structuraux non traversants de type creux ou puits.

### 1.4. Phase de bouchage des défauts structuraux non traversants 35

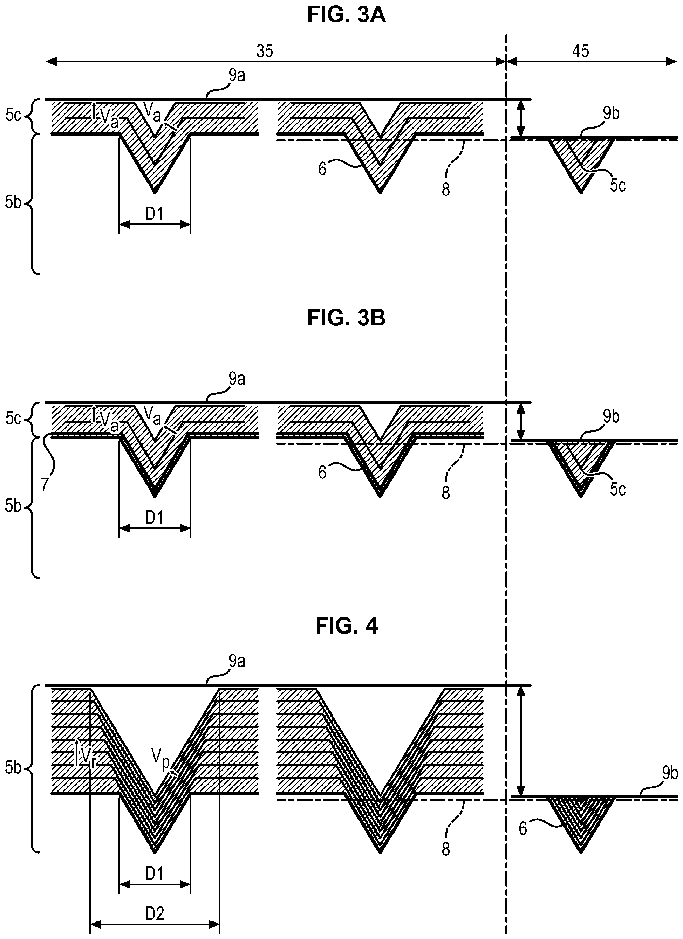

Les figures 3A et 3B illustrent l'étape de bouchage 35 de macrodéfauts structuraux non traversants 6 selon différents modes de mise en œuvre possibles décrits ci-dessous.

Dans une étape préalable, les macrodéfauts permanents ou structuraux non traversants 6 sont déterminés sur des échantillons typiques. Typiquement, les macrodéfauts permanents ou structuraux non traversants 6 auront un diamètre équivalent compris entre 20 à 1000 micromètres.

Le diamètre équivalent d'un défaut permanent est sa plus grande dimension d'ouverture déterminée par observation au microscope optique.

Cette étape de mesure de taille des défauts et la recherche du plus grand diamètre et de plus grande profondeur pour une couche 5b d'épaisseur donnée permet de calibrer le procédé en vue de déterminer le temps à allouer à l'étape de bouchage 35 afin d'obtenir une couche 5c comblant les macrodéfauts permanents ou structuraux non traversants 6 de la couche monocristalline 5b.

L'épaisseur de la couche 5c est comprise entre 50 et 100% de la valeur du plus grand diamètre équivalent des macrodéfauts structuraux non traversants 6.

Un diamètre équivalent de défaut est déterminé, correspondant au diamètre d'un disque parfait de même aire que celui mesuré pour ledit défaut.

Le plus grand diamètre équivalent est identifié statistiquement sur un lot d'échantillons de cristal 5. Par observation au microscope de la surface de la couche 5b du cristal 5, on examine les macrodéfauts le long d'un axe horizontal du cristal 5 pris au hasard, et le long d'un second axe horizontal perpendiculaire à ce premier axe, et l'on mesure le diamètre équivalent de ces macrodéfauts. La profondeur est mesurée par déplacement de la vis micrométrique de l'optique du microscope qui permet la mise au point afin d'observer la surface du défaut et le fond du défaut. Le défaut de plus grande surface et de plus grande profondeur est le défaut pris en compte afin de régler les paramètres de la phase de bouchage.

La densité surfacique de macrodéfauts peut être déterminée en rapportant la somme des aires de chaque défaut permanent dont la surface est le disque de diamètre équivalent précédemment mentionné, sur la surface de la couche de cristal après bouchage, ou sur celle de la plaquette après finition, observée par microscopie optique.

Ensuite, l'on procède, à la phase de bouchage des défauts structuraux non traversants en poursuivant le dépôt dans des conditions, décrites ci-après, propres à créer le dépôt d'une couche 5c polycristalline continue de nitrure d'élément 13 recouvrant toute la face supérieur de la couche sous-jacente 5b, et pouvant comporter une épaisseur comprise entre 0.1 et 1mm, de préférence de 0.1 à 0.5 mm.

Selon un premier mode de mise en œuvre possible ne faisaint pas partie de l'invention de l'étape de bouchage 35, tel qu'illustré en figure 3A, la température de croissance est fortement réduite de 100°C, de préférence plus de 200°C voire plus de 300°C et/ou la vitesse de croissance est fortement augmentée. Ainsi, la température de croissance est abaissée à 700° ou moins, voire 600°C ou moins, et la vitesse de croissance augmentée est au moins 10 fois supérieure à celle de la croissance de la couche 5a ou 5b, en particulier supérieure à 1000 micromètres/h. Ces conditions de dépôt permettent en effet la croissance de la couche polycristalline 5c directement sur la couche monocristalline 5b.

Dans ces conditions extrêmes, le dépôt se dégrade au point de réaliser un dépôt polycristallin.

Ce premier mode de mise en œuvre possible de l'invention permet une très bonne adhésion de la couche polycristalline 5c sur la couche sous-jacente monocristalline 5b. La couche polycristalline 5c comblant ou remplissant les creux ou puits 6 est suffisamment consolidée pour subir un usinage dans une étape de rectification 45, décrite ci-après dans la description.

Selon un deuxième mode de mise en œuvre possible de l'invention de l'étape de bouchage 35, tel qu'illustré en figure 3B, on réalise une étape de dépôt d'une couche continue amorphe et/ou microcristalline 7. Cette étape peut être réalisée avant l'étape de bouchage 35.

Ce dépôt de couche continue amorphe et/ou microcristalline 7 est réalisé afin de bloquer l'épitaxie de la couche suivante et également pour former plus facilement ladite couche polycristalline de la phase de bouchage 35.

La couche 7 est amorphe, et est à base de Silicium, ou à base de nitrure de Silicium. Un dépôt préalable de SiN amorphe est particulière adapté car il adhère parfaitement à la couche monocristalline de nitrure d'élément 13, tout particulièrement dans le cas du GaN.

Un tel dépôt amorphe 7 présente typiquement une épaisseur de 0.1 à 0.5 micromètre, de préférence inférieure à 0.2 micromètre. La vitesse de dépôt d'une telle couche, est par exemple, de 0.1 à 0.2 micromètre/h.

Ensuite, le processus de croissance est repris et les défauts structuraux non traversants 6 sont comblés par une couche de GaN polycristalline 5c.

Une fois, cette reprise de croissance provoquée, on adopte des conditions de croissance assez similaires de température et de pression à celles du dépôt de la couche monocristalline 5b.

Le dépôt de cette couche polycristalline 5b peut donc se faire dans la gamme de température utilisée pour la croissance de la couche monocristalline 5a, c'est-à-dire entre 900-1150°C.

Ainsi, ce mode de mise en œuvre possible de l'invention permet avantageusement un gain de temps, les conditions du réacteur ne variant pas entre la formation des différentes couches 5b et 5c.

En outre, l'avantage particulier de ce deuxième mode est de remplir les creux 6 sans créer de nouveaux défauts structuraux au sein de la première couche monocristalline 5a et sans créer de contraintes mécaniques sur la deuxième couche 5b.

De manière avantageuse, dans ce deuxième mode de mise en œuvre de l'invention, pour optimiser la durée et si nécessaire accentuer le caractère polycristallin de cette couche, on peut augmenter la vitesse de croissance et/ou réduire la température de croissance de la couche GaN polycristalline, dans les conditions similaires au premier mode de mise en œuvre décrit ci-dessus.

Le dépôt d'une couche de GaN polycristalline sur la surface supérieure d'une couche monocristalline de GaN est connu de l'état de la technique, cependant le dépôt d'une couche polycristalline afin de boucher des défauts structuraux non traversants 6 est inconnu de l'art antérieur.

Ainsi, le document US8349711 B2 propose un dépôt polycristallin afin de renforcer mécaniquement une couche monocristalline. Il est ainsi expliqué qu'une telle couche peut être obtenue en réduisant la température de croissance de 20°C à 990°C et en augmentant le flux d'ammoniac de 1600 à 6000 sccm (« standard cubic centimeters per minute » soit 1 cm³ par minute à 0°C et sous une pression de 1bar). Le flux d'HCl est maintenu à 120 sccm pour une vitesse de croissance de 330 µm/heure.

Cette vitesse est cependant extrêmement faible et ne peut convenir pour combler les macro-défauts non traversants, observés sur les couches de fortes épaisseurs, tels que dans la présente invention.

Le document US2012/0015143 divulgue un substrat monocristallin à surface texturée pour la croissance de monocristaux par voie épitaxiale. La texture superficielle est obtenue en déposant sur le monocristal un dépôt polycristallin. La couche polycristalline est déposée puis traitée chimiquement afin d'attaquer les joints de grains et obtenir une surface nano-structurée. La couche polycristalline est donc uniquement utilisée dans le but de structurer le substrat, elle n'est pas utilisée dans le but de combler les défauts structuraux non traversants d'une couche monocristalline

Ainsi, de manière avantageuse et inconnue de l'état de la technique, l'invention propose un procédé de bouchage 35 de défauts structuraux non traversants 6 d'une couche monocristalline 5b par le dépôt d'une couche polycristalline 5c.

On notera en référence à la figure 4 que si un homme du métier envisageait de combler les défauts non traversants 6 par des dépôts continus, il serait amené naturellement à procéder à un bouchage par croissance monocristalline.

Néanmoins, une telle mise en œuvre ne serait pas satisfaisante.

En particulier la vitesse de croissance n'est pas uniforme entre les zones avec et sans défauts non traversants. Ainsi la vitesse de croissance Vr sur un plan sans défauts structuraux sera plus importante que la vitesse de croissance Vp sur un plan présentant un creux. En conséquence, le diamètre des creux 6, s'élargit au fur et à mesure que la couche monocristalline croît, le diamètre équivalent D2 des creux après bouchage est supérieur au diamètre équivalent D1 avant bouchage, le défaut structurel s'élargit donc.

En comparaison, dans le cas d'une croissance polycristalline, telle que proposée et illustrée aux figures 3A et 3B, la vitesse de croissance Va est constante sur tous les plans de croissance ; le diamètre des creux 6 reste donc également constant au cours de la croissance de la couche polycristalline.

En outre, le dépôt de couches polycristallines nécessite une épaisseur de matière moins importante pour combler les défauts non traversants 6 de la première couche monocristalline 5b. Le procédé proposé est donc moins onéreux.

### 1.5. Phase de séparation 40

Une phase 40 de séparation est également mise en œuvre, celle-ci est dépendante de la variante implémentée pour la phase 20 de formation de la zone de séparation 4.

Dans le cas d'une implantation d'ions, la phase 40 de séparation spontanée a lieu du fait du cycle thermique (reprise d'épitaxie à haute température et refroidissement) que subit la couche épaissie de GaN 5 qui, à cause de la différence de coefficients de dilatation thermique entre le substrat de départ 1 et la couche épaisse de GaN 5, engendre des contraintes provoquant sa séparation.

Dans le cas du dépôt d'une couche intermédiaire de silicium, cette séparation intervient durant la reprise d'épitaxie par vaporisation spontanée de la couche intermédiaire de silicium.

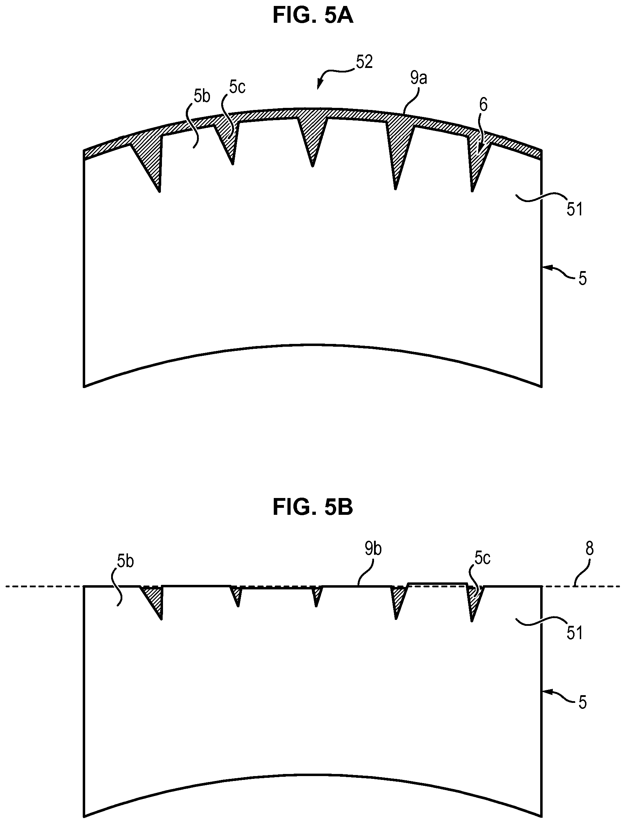

On obtient ainsi un cristal de GaN 5 autosupporté tel qu'illustré à la figure 5.

Comme il est courant en HVPE, le cristal de GaN 5, tel qu'illustré en figure 5A, comprend des excroissances 51 sous forme de pyramides hexagonales sur une face avant 52, délimitant des puits ou défauts macrostructuraux non traversants 6 dans la zone monocristalline 5b et des zones polycristallines 5c

Un tel cristal est bombé et présente un rayon de courbure inférieur à 25 mètres et préférentiellement inférieur à 20 mètres (rayon de courbure de la face avant 52, comme de la face du cristal opposée à ladite face avant 52).

Dans l'exemple de la figure 5A, ce rayon de courbure est de 5 mètres ou plus ; par ailleurs, le cristal 5 a en outre une densité de dislocation de 10⁷cm⁻² ou inférieure.

Le cristal de GaN 5 ayant été formé sur un substrat de départ présentant un angle de troncature non nul, celui-ci présente également un angle de troncature non nul, l'orientation des plans cristallins se propageant d'une couche à l'autre. Par exemple, dans le cas d'un substrat de saphir 1 d'angle de troncature égale à 4 degrés, la face de croissance du cristal 5 présente un angle de troncature égale à 4 degrés sur toute sa surface.

### 1.6. Phase de rectification 45

Une fois le cristal de GaN 5 séparé du substrat de départ 1, on procède à l'élimination de la couche finale de nitrure d'élément 13 afin d'enlever la couche polycristalline 5c sur toute son épaisseur excepté au niveau desdits défauts structuraux 6. Un tel cristal, après rectification, est représenté en figure 5B.

De préférence, l'élimination 45 de la couche polycristalline est réalisée par usinage, par exemple par rectification.

Les techniques actuelles permettent de contrôler l'élimination d'une épaisseur de couche à 10 micromètres près. L'élimination en particulier d'une couche polycristalline 5c composée de nitrure de Gallium (GaN et variantes GaAlN, GaInN etc...) n'est réellement possible que par usinage mécanique, une attaque chimique étant insuffisante dans ce cas précis.

La face supérieure 9a du cristal de GaN 5 est éliminée par usinage jusqu'à un niveau de rectification 8, définissant après rectification une face supérieure 9b, telle qu'illustrée en figure 3A et 3B. Ce niveau de rectification 8 correspond à l'épaisseur de la (ou des) couche(s) polycristalline(s) 5c déposée(s), la (ou les) couche(s) polycristalline(s) 5c étant ainsi éliminée(s), à l'exception des zones de la couche monocristalline 5b correspondant aux défauts structuraux non traversants 6 que ladite (ou lesdites) couche(s) polycristalline(s) 5c rempli(ssen)t.

Après les phases de séparation 40 et de rectification 45, on obtient ainsi un substrat de matériau semi-conducteur (5) de nitrure d'élément 13 comprenant sur sa face supérieure (9b) au moins une couche monocristalline (5b) présentant des discontinuités (6) correspondant à des défauts structuraux non traversants de diamètre équivalent et/ou de profondeur de 20 à 1000 micromètres bouchés ou remplis par au moins une couche polycristalline (5c) continue, ledit substrat présentant une épaisseur d'au moins 300 micromètres. De plus, avantageusement, ledit substrat présente une largeur de raie de double diffraction aux rayons X de l'ordre de 100 arcsec ou moins, de préférence de 80 arcsec ou moins, ou de l'ordre de 60 arcsec ou moins.

La comparaison entre les figures 3A, 3B et la figure 4 montre bien l'avantage du procédé selon l'invention. Comme expliqué, dans l'étape 35, le bouchage se réalisant avec une vitesse de croissance plus uniforme dans le procédé selon l'invention, le bouchage se réalise plus rapidement, la perte de matière à l'usinage est donc plus faible qu'avec un substrat bouché par dépôt monocristallin, l'épaisseur de couche enlevée étant nettement inférieure dans le cas d'un dépôt polycristallin.

En outre, dans le procédé de la figure 3, la perte de matériau d'usinage est essentiellement de type amorphe ou polycristallin, il s'agit d'un matériau moins noble et donc moins coûteux que le matériau monocristallin.

### 1.7. Phase de finition 50

On procède ensuite à l'opération de finition pour former des plaquettes GaN présentant une largeur de raie de double diffraction aux rayons X de l'ordre de 100 arcsec ou moins, de préférence de 80 arcsec ou moins, de l'ordre de 60 arcsec ou moins.

On procède à une rectification de la face arrière et des côtés ou chants de la plaquette, au polissage afin d'obtenir un état de surface acceptable pour la réalisation de structures semi-conductrices, telles que des diodes électroluminescentes (DEL), ou des diodes laser (DL).

Ainsi, le procédé proposé est particulièrement adapté à la fabrication de tranches de matériau semi-conducteur, notamment des tranches de matériau d'élément de groupe 13 et 15 du tableau périodique, plus particulièrement des tranches composées de nitrure d'élément 13, de préférence de GaN, de grande taille , supérieure à 5 centimètres , de plus 10 centimètres ou même 15 à 20 centimètres.

La tranche de matériau semi-conducteur selon les figures 3A et 3B présente une épaisseur de l'ordre de 450 micromètres et une excellente qualité cristalline de largeur de raie de double diffraction aux rayons X de l'ordre de 60 à 80 arcsec, ainsi qu'une densité surfacique de défauts structuraux non traversants 6 de l'ordre de 1,3%. Tandis que la tranche de la figure 4, formée par bouchage par une couche monocristalline, présente une qualité cristalline de 130 à 150 arcsec, pour une densité surfacique de défauts structuraux non traversants 6 similaire.

Dans la description qui précède, le procédé selon l'invention a été décrit en référence à la fabrication d'un substrat de matériau semi-conducteur composé de nitrure d'élément 13, de préférence de GaN. Toutefois, il est bien évident pour l'homme du métier que le procédé décrit ci-dessus peut être utilisé pour faire la fabrication d'un substrat incluant une couche de nitrure d'élément 13 autre que du nitrure de gallium GaN, ce matériau pouvant être utilisé pour réaliser des structures semi-conductrices telles que des diodes électroluminescentes.

## Revendications

1. Procédé de fabrication d'un substrat semi-conducteur (5) de nitrure d'élément de groupe 13 comprenant les étapes suivantes de :
a) dépôt d'au moins une couche monocristalline (5b) de nitrure d'élément de groupe 13 par croissance épitaxiale (10) sur un substrat de départ, ladite couche monocristalline présentant une face supérieure présentant des défauts structuraux non traversants (6) ;
b) dépôt (30) d'au moins une couche polycristalline continue de nitrure d'élément de groupe 13 (5c) sur toute la face supérieure de la couche monocrystalline afin de boucher les défauts structurants non traversants ;
c) séparation (40) du substrat de départ (1) ;
d) rectification (50) par élimination d'au moins une épaisseur de couche correspondant à l'épaisseur de la, ou des, couche(s) polycristalline(s) (5c) déposée(s), la, ou les, couche(s) polycristalline(s) (5c) étant ainsi éliminée(s), à l'exception des zones de la couche monocristalline sous-jacente (5b) correspondant aux défauts structuraux non traversants (6) que ladite, ou lesdites, couche(s) polycristalline(s) (5c) rempli(ssen)t ; l'étape b) étant précédée d'une étape de dépôt d'une couche continue amorphe (7) sur toute la face supérieure de la couche monocristalline, ladite couche amorphe étant une couche à base de Silicium ou de nitrure de Silicium.

2. Procédé de fabrication selon la revendication 1 dans lequel l'étape b) met en œuvre une croissance à une température inférieure de plus de 100°C, préferentiellement de plus de 200°C et encore plus préférentiellement de plus de 300°C, à la température de croissance lors du dépôt de la couche monocristalline.

3. Procédé de fabrication selon l'une des revendications précédentes dans lequel l'étape b) met en œuvre une croissance à une température de croissance de 700°C ou moins, voire 600°C ou moins.

4. Procédé de fabrication selon l'une des revendications précédentes dans lequel l'étape b) met en œuvre une croissance à une vitesse de croissance supérieure à 1000 micromètres/h et/ou d'au moins 10 fois la vitesse de croissance de la couche monocristalline (5b) sous-jacente.

5. Procédé de fabrication selon l'une des revendications précédentes dans lequel l'étape b) comporte une étape préalable de détermination des défauts structuraux non traversants de diamètre équivalent et/ou de profondeur de à 20 à 1000 micromètres.

6. Procédé de fabrication selon l'une des revendications précédentes, dans lequel la couche amorphe comporte une épaisseur de 0.1 à 0.5 micromètre, de préférence inférieure à 0.2 micromètre.

7. Procédé de fabrication selon l'une des revendications précédentes dans lequel le dépôt de la couche polycristalline comprend une température de croissance comprise entre 900 et 1150°C.

8. Procédé de fabrication selon l'une des revendications précédentes dans lequel la couche de nitrure d'élément 13 est une couche de nitrure de gallium.

9. Procédé de fabrication selon l'une des revendications précédentes dans lequel la couche monocristalline comporte une épaisseur supérieure à 300 micromètres, ou supérieure à 500 micromètres.

10. Procédé de fabrication selon l'une des revendications précédentes dans lequel la couche polycristalline comporte une épaisseur comprise entre 0.1 et 1 mm, ou comprise entre 0.1 et 0.5 mm.

11. Substrat semi-conducteur (5) de nitrure d'élément de groupe 13 comprenant au moins une couche monocristalline de nitrure d'élément de groupe 13 (5b) présentant une face supérieure (9b), ladite face supérieure (9b) présentant des défauts structuraux non traversants (6) remplis par au moins une couche polycristalline de nitrure d'élément de groupe 13 (5c) continue, une couche continue amorphe étant présent entre la couche monocristalline de nitrure d'élément de groupe 13 et la couche polycristalline de nitrure d'élément de groupe 13, la couche amorphe étant une couche à base de silicium ou de nitrure de silicium.

12. Substrat de matériau semi-conducteur (5) de nitrure d'élément de groupe 13 selon la revendication précédente dans lequel lesdits défauts structuraux non traversants sont de diamètre équivalent et/ou de profondeur de 20 à 1000 micromètres.

13. Substrat de matériau semi-conducteur (5) de nitrure d'élément de groupe 13 selon la revendication précédente dans lequel ledit substrat présente une épaisseur d'au moins 300 micromètres, et une largeur de raie de double diffraction aux rayons X de 100 arcsec ou moins, de préférence de 80 arcsec ou moins, ou de 60 arcsec ou moins.

## Patentansprüche

1. Herstellungsverfahren eines Halbleiter-Substrats (5) aus einem Nitridelement der Gruppe 13, umfassend die folgenden Schritte:
a) Aufbringen wenigstens einer Monokristallin-Schicht (5b) aus einem Nitridelement der Gruppe 13 durch epitaxiales Wachstum (10) auf einem Ausgangssubstrat, wobei die genannte monokristalline Schicht eine obere Seite aufweist, die nicht durchquerende Strukturfehler (6) aufweist;
b) Aufbringen (30) wenigstens einer kontinuierlichen polykristallinen Schicht aus einem Nitridelement der Gruppe 13 (5c) auf der gesamten oberen Fläche der monokristallinen Schicht zum Stopfen der nicht durchquerenden, strukturierenden Fehler;
c) Trennen (40) des Ausgangssubstrats (1);
d) Begradigen (50) per Eliminieren wenigstens einer Dicke der Schicht, die der Dicke der polykristallinen aufgebrachten Schicht(en) (5c) entspricht, wobei die polykristalline(n) aufgebrachte(n) Schicht(en) (5c) somit mit Ausnahme der Bereiche der zugrunde liegenden monokristallinen Schicht (5b) eliminiert werden, die den nicht durchquerenden strukturellen Fehlern (6) entspricht (entsprechen), die die genannte(n) polykristalline(n) Schicht(en) (5c) füllen; wobei dem Schritt b) ein Aufbringungsschritt einer kontinuierlichen amorphen Schicht (7) auf der gesamten oberen Seite der monokristallinen Schicht vorausgeht, wobei die genannte amorphe Schicht eine Schicht auf Silizium- oder Siliziumnitridbasis ist.

2. Herstellungsverfahren gemäß Anspruch 1, bei dem der Schritt b) ein Wachstum bei einer Temperatur von weniger als plus 100° C, bevorzugt von mehr als 200° C und weiter bevorzugt von mehr als 300° C zu der Wachstumstemperatur beim Aufbringen der monokristallinen Schicht umsetzt.

3. Herstellungsverfahren gemäß einem der voranstehenden Ansprüche, in dem der Schritt b) ein Wachstum bei einer Wachstumstemperatur von 700° C oder weniger bzw. 600° C oder weniger umsetzt.

4. Herstellungsverfahren gemäß einem der voranstehenden Ansprüche, bei dem der Schritt b) ein Wachstum bei einer Wachstumsgeschwindigkeit von mehr als 1000 Mikrometern / Std. und / oder wenigstens dem 10-Fachen der Wachstumsgeschwindigkeit der zugrunde liegenden monokristallinen Schicht (5b) umsetzt.

5. Herstellungsverfahren gemäß einem der voranstehenden Ansprüche, bei dem der Schritt b) einen vorherigen Bestimmungsschritt der nicht durchquerenden Strukturfehler mit einem äquivalenten Durchmesser und / oder einer Tiefe von 20 bis 1000 Mikrometern umfasst.

6. Herstellungsverfahren gemäß einem der voranstehenden Ansprüche, bei dem die amorphe Schicht eine Dicke von 0,1 bis 0,5 Mikrometer, bevorzugt kleiner als 0,2 Mikrometer, umfasst.

7. Herstellungsverfahren gemäß einem der voranstehenden Ansprüche, bei dem das Aufbringen der polykristallinen Schicht eine zwischen 900 und 1150° C inbegriffene Wachstumstemperatur umfasst.

8. Herstellungsverfahren gemäß einem der voranstehenden Ansprüche, bei dem die Schicht aus einem Nitridelement 13 eine Schicht aus Galliumnitrid ist.

9. Herstellungsverfahren gemäß einem der voranstehenden Ansprüche, bei dem die monokristalline Schicht eine Dicke größer als 300 Mikrometer oder größer als 500 Mikrometer umfasst.

10. Herstellungsverfahren gemäß einem der voranstehenden Ansprüche, bei dem die polykristalline Schicht eine zwischen 0,1 und 1 mm inbegriffene oder zwischen 0,1 und 0,5 mm inbegriffene Dicke umfasst.

11. Halbleitersubstrat (5) aus einem Nitridelement der Gruppe 13, umfassend wenigstens eine monokristalline Schicht aus einem Nitridelement der Gruppe 13 (5b), die eine obere Seite (9b) aufweist, wobei die genannte obere Seite (9b) nicht durchquerende Strukturfehler (6) aufweist, die von wenigstens einer kontinuierlichen polykristallinen Schicht (5c) aus einem Nitridelement der Gruppe 13 besteht, wobei eine kontinuierliche amorphe Schicht zwischen der monokristallinen Schicht aus einem Nitridelement der Gruppe 13 und der polykristallinen Schicht aus einem Nitridelement der Gruppe 13 vorhanden ist, wobei die amorphe Schicht eine Schicht auf Silizium- oder Siliziumnitrid-Basis ist.

12. Halbleitersubstrat (5) aus einem Nitridelement der Gruppe 13 gemäß dem voranstehenden Anspruch, bei dem die genannten nicht durchquerenden Strukturfehler einen äquivalenten Durchmesser und / oder eine Tiefe von 20 bis 1000 Mikrometer aufweisen.

13. Halbleitersubstrat (5) aus einem Nitridelement der Gruppe 13 gemäß dem voranstehenden Anspruch, bei dem das genannte Substrat eine Dicke von wenigstens 300 Mikrometern und eine spektrale Linienbreite doppelter Brechung gegenüber Röntgenstrahlen mit 100 Arcsec oder weniger, bevorzugt zwischen 80 Arcsec oder weniger oder 60 Arcsec oder weniger aufweist.

## Claims

1. A method for manufacturing a semiconductor substrate (5) of a group 13 element nitride including the following steps of:
a) depositing at least one single crystal layer (5b) by epitaxial growth (10) on a starting substrate, said single crystal layer having an upper face having non-through structural defects (6) ;
b) depositing (30) at least one continuous polycrystalline layer of a group 13 element nitride (5c) over the entire upper face the single crystal layer in order to plug the non-through structural defects;
c) separating (40) the starting substrate (1);
d) grinding (50) by removing at least one thickness of layer corresponding to the thickness of the polycrystalline layer (or layers) (5c) deposited, the polycrystalline layer (or layers) (5c) thus being removed, except for the zones of the subjacent single crystal layer (5b) corresponding to the non-through structural defects (6) filled with said polycrystalline layer (or layers) (5c);
step b) being preceded by a step of depositing a continuous amorphous layer (7) over the entire upper face of the single crystal layer, said amorphous layer being a silicon-based or silicon nitride-based layer.

2. The manufacturing method as claimed in claim 1, wherein step b) implements growth at a temperature of more than 100 °C (preferably more than 200 °C and even more preferably more than 300 °C) lower than the growth temperature upon depositing the single crystal layer.

3. The manufacturing method as claimed in one of the preceding claims, wherein step b) implements a growth at a growth temperature of 700 °C or less, or even 600 °C or less.

4. The manufacturing method as claimed in one of the preceding claims, wherein step b) implements a growth at a growth rate greater than 1000 micrometers/h and/or at least 10 times the growth rate of the subjacent single crystal layer (5b).

5. The manufacturing method as claimed in one of the preceding claims, wherein step b) comprises a prior step of determining non-through structural defects of an equivalent diameter and/or depth of 20 to 1000 micrometers.

6. The manufacturing method as claimed in one the preceding claims, wherein the amorphous layer has a thickness of 0.1 to 0.5 micrometer, preferably less than 0.2 micrometer.

7. The manufacturing method as claimed in one the preceding claims, wherein depositing the amorphous and/or microcrystalline layer comprises a growth temperature of between 900 °C and 1150 °C.

8. The manufacturing method as claimed in one the preceding claims, wherein the group 13 element nitride layer is a layer of gallium nitride.

9. The manufacturing method as claimed in one of the preceding claims, wherein the single crystal layer has a thickness greater than 300 micrometers, or greater than 500 micrometers.

10. The manufacturing method as claimed in one of the preceding claims, wherein the polycrystalline layer has a thickness of between 0.1 and 1 mm, or between 0.1 and 0.5 mm.

11. A semiconductor substrate (5) of group 13 element nitride including at least one group 13 element nitride single crystal layer (5b) having an upper face (9b), said upper face (9b) having non-through structural defects (6) filled with at least one group 13 element nitride continuous polycrystalline layer (5c), a continuous amorphous layer being present between the group 13 element nitride single crystal layer and the group 13 element nitride polycrystalline layer, the amorphous layer being a silicon-based or silicon nitride-based layer.

12. The semiconductor material substrate (5) of group 13 element nitride according to the preceding claim, wherein said non-through structural defects are of an equivalent diameter and/or a depth of 20 to 1 000 micrometres.

13. The semiconductor material substrate (5) of group 13 element nitride according to the preceding claim, wherein said substrate has a thickness of at least 300 micrometres, and a double X-ray diffraction line width of 100 arcsec or less, preferably 80 arcsec or less, or 60 arcsec or less.
